# EUROPEAN PATENT SPECIFICATION

(11) **EP 1 702 372 B1**
(45) Date of publication and mention of the grant of the patent: **01.09.2010**
(21) Application number: 04807027.0
(22) Date of filing: 08.12.2004
(51) Int. Cl.: H01L 51/30, C08G 61/12

(54) **POLYMER FOR ANODE BUFFER LAYER, COATING SOLUTION FOR ANODE BUFFER LAYER, AND ORGANIC LIGHT EMITTING DEVICE**
POLYMER FÜR EINE ANODENPUFFERSCHICHT, BESCHICHTUNGSLÖSUNG FÜR EINE ANODENPUFFERSCHICHT UND ORGANISCHES LICHTEMISSIONSBAUELEMENT
POLYMERE POUR COUCHE TAMPON D'ANODE, SOLUTION DE REVETEMENT POUR CETTE COUCHE, ET DISPOSITIF ELECTROLUMINESCENT

(30) Priority: 09.12.2003 JP 2003410097
(43) Date of publication of application: 20.09.2006
(73) Proprietor: Showa Denko K.K., Tokyo 105-8518 (JP)
(72) Inventor: KOYAMA, Tamami,, Chiba-shi, Chiba 267-0056 (JP); KONDO, Kunio,, Chiba-shi, Chiba 267-0056 (JP)
(74) Representative: Strehl Schübel-Hopf & Partner
(86) International application number: PCT/JP2004/018668
(87) International publication number: WO 2005/057677

(56) References cited:
- WO-A-01/18888
- WO-A-87/05914
- PATENT ABSTRACTS OF JAPAN vol. 1998, no. 10, 31 August 1998 (1998-08-31) -& JP 10 140141 A (SHOWA DENKO KK), 26 May 1998 (1998-05-26)
- PATENT ABSTRACTS OF JAPAN vol. 1998, no. 11, 30 September 1998 (1998-09-30) & JP 10 168328 A (SHOWA DENKO KK), 23 June 1998 (1998-06-23)

## Description

### TECHNICAL FIELD

The present invention relates to an organic light emitting device comprising an anode buffer layer using a self doped polymer according to claim 1.

### BACKGROUND ART

Typical structure of conventional organic polymer light emitting devices is such that an anode (transparent), an anode buffer layer, a light emitting layer, and a cathode are formed in this order on a transparent substrate. The anode buffer layer is inserted to make the anode surface flat, thereby preventing electrical short circuit, and to buffer the injection barrier for the hole injection from the light emitting layer to the anode.

A conductive polymer material comprising a mixture of a poly(3,4-ethylenedioxythiophene) (PEDOT) and a polystyrene sulfonate (PSS) iswidelyusedintheanodebuffer layer. However, the anode buffer layer using the mixture is disadvantageous in that the polystyrene sulfonate is contained as an extrinsic dopant and penetrates into the light emitting layer to deteriorate the light emitting layer.

With respect to the problem caused by the extrinsic dopant in the anode buffer layer, a method of using a self-doping conductive polymer in an anode buffer layer without the extrinsic dopant is disclosed in JP-T-2003-509816 (WO01/018888). In this document, polyanilines, polyphenylenevinylenes, polythiophenes, polyisothianaphthenes,poly (p-phenylene)s,etc. are illustrated as preferred intrinsic conductive polymers capable of forming a backbone of the self-doping conductive polymer. Further, in this document, preferred self-doping conductive polymers include self-doping polyanilines, self-doping polypyrroles, and self-doping polythiophenes, and self-doping sulfonated polyanilines are described as the most preferred ones with reference to embodiments and Examples.

The use of a conductive microgel comprising self-doped sulfonated isothianaphthene polymer having a pH value of 3 to 7 to obtain antistatic articles is disclosed in JP 10 140141 A. International application WO87/05914 discloses self-doped conducting polymers having along its backbone a π-electron conjugated system which comprises a plurality of monomer units, said units having linked thereto at least one Bronsted acid group.

### DISCLOSURE OF THE INVENTION

As describe above, to overcome the problem of the deterioration of the light emitting layer due to the extrinsic dopant in the conventional anode buffer layers, the anode buffer layer using the self-doping sulfonated polyaniline is proposed in JP-T-2003-509816(WO01/018888). However, the conductivity of the polyaniline is approximately 10⁻¹ to 10⁻³ S/cm and insufficient for the anode buffer layer, and the polyaniline shows a sufficient conductivity only in a case where an aqueous coating solution of the polyaniline has a high acidity (a pH value of 3 or less).

Further, embodiments of the other preferred conductive polymers are not described in the above document at all. Thus, though the self-doping conductive polymers has been proposed in order to solve the problem of the light emitting layer deterioration due to the extrinsic dopant in the anode buffer layer, there are no self-doping conductive polymers that can be practically used in the device.

Accordingly, an object of the present invention is to overcome the problem of the anode buffer layer in the organic polymer light emitting devices, thereby providing a self-doping conductive polymer material that can be practically used in an anode buffer layer, and an organic light emitting device using the same.

As a result of various research in view of the above object, the inventors have found that properties of organic light emitting devices can be improved by using an anode buffer layer comprising a self-doping conductive polymer material showing a low acidity in form of an aqueous solution. The present invention has been accomplished by this finding.

Thus, the invention relates to a polymer for anode buffer layer in an organic light emitting device, a coating solution for anode buffer layer comprising the polymer, and an organic light emitting device comprising the anode buffer layer as defined in claim 1.

### BRIEF DESCRIPTION OF THE DRAWINGS

Fig. 1 is a cross-sectional view showing an example of an organic light emitting device of the present invention.
Fig. 2 shows examples of the structure of a non-conjugated phosphorescent polymers useful in the organic light emitting device of the invention.

### DETAILED DESCRIPTION OF INVENTION

An embodiment of the present invention is described below specifically with reference to drawings.

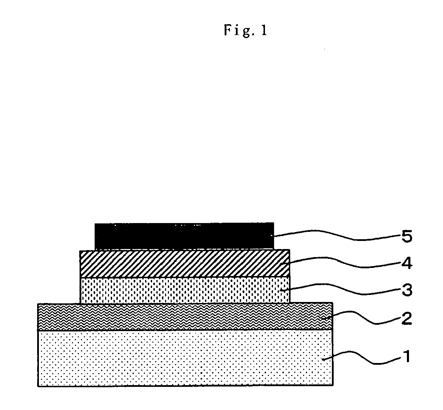

Fig. 1 is a cross-sectional view showing an example of structure of the organic light emitting device according to the invention, and the structure is such that an anode buffer layer (3) and a light emitting layer (4) are subsequently formed between an anode (2) and a cathode(5) disposed on a transparent substrate (1). The structure of the organic light emitting device of the invention is not limited to the example of Fig. 1, and may subsequently comprise, between an anode and a cathode, 1) an anode buffer layer, a hole transporting layer, and a light emitting layer, 2) an anode buffer layer, a light emitting layer, and an electron transporting layer, 3) an anode buffer layer, a hole transporting layer, a light emitting layer, and an electron transporting layer, 4) an anode buffer layer and a layer containing a hole transporting material, a light emitting material and an electron transporting material, 5) an anode buffer layer and a layer containing a hole transporting material and a light emitting material, or 6) an anode buffer layer and a layer containing a light emitting material and an electron transporting material. Further, though the structure shown in Fig. 1 has one light emitting layer, the organic light emitting device of the invention may have two or more light emitting layers.

According to a first aspect of the invention, there is provided a polymer for the anode buffer layer, which is a self-doping conductive polymer having a pH value of 3 to 7 in a 1% by mass aqueous solution.

The 1% by mass aqueous solution of the self-doping conductive polymer further preferably has a pH value of 4 to 6.

For example, the anode buffer polymer according to the first aspect of the invention is preferably a polymer comprising a monomer unit represented by the following formula (1) : 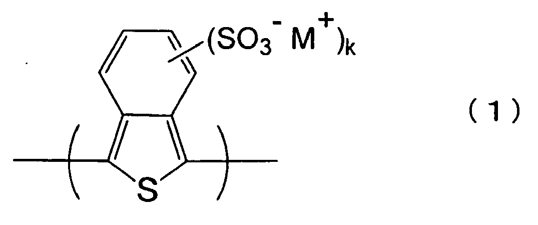 [wherein M⁺ represents a hydrogen ion, an alkali metal ion, or a quaternary ammonium ion, and k represents 1 or 2], and/or a monomer unit, which is provided by electrochemically doping the monomer unit of the formula (1), represented by the following formula (2): 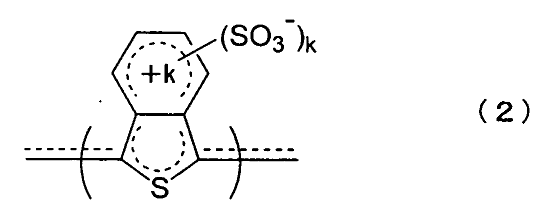 [wherein k represents 1 or 2, and +k represents a positive charge number].

The monomer units represented by the formulae (1) and (2) have one or two sulfonic acid groups, which may be bonded to any one of the 4-, 5-, 6-, and 7-positions.

In the formula (1), M⁺ represents a hydrogen ion, an alkali metal ion, or a quaternary ammonium ion, and the monomer unit may contain two or more different cations selected therefrom.

Examples of the alkali metal ions include Na⁺, Li⁺, and K⁺.

The quaternary ammonium ion is represented by N(R¹) (R²)(R³)(R⁴)⁺. R¹ to R⁴ independently represent a hydrogen atom, a linear or branched, substituted or non-substituted alkyl group having 1 to 30 carbon atoms, or a substituted or non-substituted aryl group. The alkyl and aryl groups may contain a group with an atom other than carbon and hydrogen atoms, such as an alkoxy group, a hydroxyl group, an oxyalkylene group, a thioalkylene group, an azo group, an azobenzene group, and a p-diphenyleneoxy group.

Examples of quaternary ammonium cation represented by N(R¹)(R²)(R³)(R⁴)⁺ include a non-substituted, alkyl-substituted, or aryl-substituted cation such as NH₄⁺, NH(CH₃)₃⁺, NH(C₆H₅)₃⁺, and N(CH₃)₂(CH₂OH)(CH₂-Z)⁺. (Z represents a substituent having a chemical formula weight of 600 or less, such as a phenoxy group, a p-diphenyleneoxy group, a p-alkoxydiphenyleneoxy group, and a p-alkoxyphenylazophenoxy group.) The cation can be converted to a specific one by using a common ion exchange resin.

The alkyl group of R¹ to R⁴ may contain a carbonyl bond, an ether bond, an ester bond, an amide bond, a sulfide bond, a sulfinyl bond, a sulfonyl bond, an imino bond, etc. optionally in the chain.

The monomer unit represented by the formula (2) can be provided by subjecting the monomer unit represented by the formula (1) to an electrochemical oxidation doping. The monomer unit represented by the formula (2) is in the self-doped state, and is kept electrically neutral by the +k charge delocalized in the aromatic ring and the main chain and by the -k charge of the sulfonic acid group.

The monomer units represented by the formula (1) and (2) may have a substituent. The substituent may be bonded to any one of the 4-, 5-, 6-, and 7-positions except for a position having the sulfonic acid group. The monomer units may have the same or different substituents.

Specific examples of the substituents include linear or branched, saturated or unsaturated alkyl groups having 1 to 20 carbon atoms, linear or branched, saturated or unsaturated alkoxy groups having 1 to 20 carbon atoms, a hydroxyl group, halogen atoms, a nitro group, a cyano group, trihalomethyl groups, a phenyl group, and substituted phenyl groups. The alkyl groups and the alkoxy groups may contain a carbonyl bond, an ether bond, an ester bond, a sulfonate bond, an amide bond, a sulfonamide bond, a sulfide bond, a sulfinyl bond, a sulfonyl bond, an imino bond, or a thioether bond, optionally in the chain.

Preferred examples of the monomer units represented by the formulae (1) or (2) include 5-sulfoisothianaphthene-1,3-diyl, 4-sulfoisothianaphthene-1,3-diyl, 4-methyl-5-sulfoisothianaphthene-1,3-diyl, 6-methyl-5-sulfoisothianaphthene-1,3-diyl, 6-methyl-4-sulfoisothianaphthene-1,3-diyl, 5-methyl-4-sulfoisothianaphthene-1,3-diyl, 6-ethyl-5-sulfoisothianaphthene-1,3-diyl, 6-propyl-5-sulfoisothianaphthene-1,3-diyl, 6-butyl-5-sulfoisothianaphthene-1,3-diyl, 6-hexyl-5-sulfoisothianaphthene-1,3-diyl, 6-decyl-5-sulfoisothianaphthene-1,3-diyl, 6-methoxy-5-sulfoisothianaphthene-1,3-diyl, 6-ethoxy-5-sulfoisothianaphthene-1,3-diyl, 6-chloro-5-sulfoisothianaphthene-1,3-diyl, 6-bromo-5-sulfoisothianaphthene-1,3-diyl, 6-trifluoromethyl-5-sulfoisothianaphthene-1,3-diyl, salts thereof such as lithium salts, sodium salts, ammonium salts, methylammonium salts, ethylammonium salts, dimethylammonium salts, diethylammonium salts, trimethylammonium salts, triethylammonium salts, tetramethylammonium salts, and tetraethylammonium salts, etc.

The polymer for the anode buffer layer may be a homopolymer comprising one type of the monomer unit represented by the formula (1) or (2), a copolymer comprising two or more types of the monomer units represented by the formula (1) or (2), or a copolymer comprising one or more types of the monomer units represented by the formula (1) or (2) and one or more types of π-electron conjugated monomer units having no sulfonic acid groups.

Examples of the π-electron conjugated monomer units having no sulfonic acid groups include vinylene, isothianaphthenylene, isobenzofurylene, isobenzoindolylene, thienylene, pyrrolylene, furylene, iminophenylene and phenylene. More than one types of the monomer units among these may be contained.

The polymer for the anode buffer layer has a sulfonic acid group, and thereby has water solubility. As the anode buffer polymer has more sulfonic acid groups, the water solubility is increased. Since most of currently-usable light emitting polymer materials are organic solvent-soluble and water-insoluble, the anode buffer polymer, whichiswater-soluble and organic solvent-insoluble, is extremely advantageous in that the anode buffer layer can be laminated with the light emitting layer by a coating process to produce the organic light emitting device.

In a case where polymer for the anode buffer layer is a copolymer comprising one or more types of the monomer units represented by the formula (1) or (2) and one or more types of the π-electron conjugated monomer units having no sulfonic acid groups, the total mole fraction of the monomer units represented by the formula (1) or (2) to the anode buffer polymer is preferably 0.2 to 1, more preferably 0.5 to 1.

The polymer for the anode buffer layer comprises the monomer unit represented by the formula (1) and/or the monomer unit represented by the formula (2). When the content of the self-doped monomer unit represented by the formula (2) is higher, the conductivity of the anode buffer polymer is higher and holes can be injected at a lower voltage, whereby the driving voltage of the device can be reduced. Even in a case where the polymer for the anode buffer layer comprising only the monomer unit represented by the formula (1) without the monomer unit represented by the formula (2) is practically used in the organic light emitting device, holes are injected from the anode to the anode buffer layer by applying electrical power, so that the monomer unit represented by the formula (1) in the anode buffer layer may be oxidized into the doped state and thus converted to the monomer unit represented by the formula (2). Thus, also the polymer comprising only the monomer unit represented by the formula (1) can be used for the anode buffer layer in the invention. The polymer comprising the monomer unit represented by the formula (1) and/or the monomer unit represented by the formula (2) can be used for the anode buffer layer in the invention without particular restrictions.

The weight average molecular weight of the self-doping polymer used in the invention is preferably within the range of 1,000 to 200,000, more preferably within the range of 5,000 to 100,000.

Particularly preferred examples of the self-doping polymers include 5-sulfoisothianaphthene-1,3-diyl polymers, random copolymers containing 80 mol% or more of 5-sulfoisothianaphthene-1,3-diyl, poly(5-sulfoisothianaphthene-1,3-diyl-co-isothianaphthene-1, 3-diyl), salts thereof such as lithium salts, sodium salts, ammonium salts, and triethylammonium salts, etc.

Among the polymer for the anode buffer layer poly(isothianaphthenesulfonic acid)s, which are the homopolymers of the monomer unit represented by the formula (1) or (2), have a smaller semiconductor bandgap of approximately 1. 0 eV, show the conductivity at a lower doping level, and achieve a more stable conducting, as compared with the other known sulfonic acid-containing conductive polymers such as polythiophene derivatives and polyaniline derivatives having an alkanesulfonic acid group. Thus, the homopolymers have a smaller visible light absorbance particularly in the doped state, and thereby can form a transparent anode buffer layer excellent in stability.

The polymer comprising the monomer unit represented by the formula (1) and/or the monomer unit represented by the formula (2), and the copolymer comprising one or more types of the monomer units represented by the formula (1) or (2) and one or more types of π-electron conjugated monomer units having no sulfonic acid groups can be produced according to methods disclosed in JP-A-6-49183 and JP-A-7-48438. By the methods, the polymer comprising the monomer unit represented by the formula (1) and/or the monomer unit represented by the formula (2) can be produced by reacting a compound represented by the following formula (3) or (4) with a sulfonating agent such as fuming sulfuric acid. 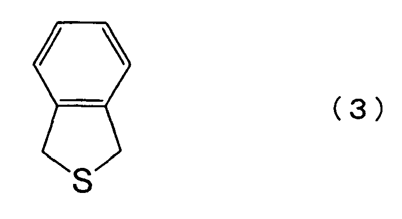 [wherein a hydrogen atom in the aromatic ring may be replaced by a substituent.] 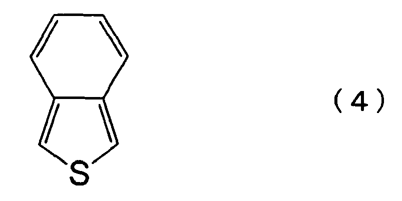 [wherein a hydrogen atom in the aromatic ring may be replaced by a substituent.]

In formula (3) and (4), examples of substituent on the aromatic ring include alkyl groups having 1 to 10 carbon atoms (such as methyl, ethyl, propyl, butyl, hexyl and decyl), alkoxy groups having 1 to 4 carbon atoms (such as methoxy and ethoxy), and halogen atoms (such as fluorine, chlorine and bromine). The above alkyl group or an alkyl group in the above alkoxy group may be substituted by a halogen atom.

Specifically, by reacting the compound represented by the formula (3) or (4) with the sulfonating agent, cationic polymerization and sulfonation proceed in one reaction liquid, so that a copolymer comprising the monomer unit represented by the formula (1) (in which M⁺ is H⁺) and the monomer unit represented by the formula (2) is generated first. The copolymer is neutralized by an alkali such as sodium hydroxide and ammonium hydroxide. In the neutralization, the pH value adjusted is preferably 3 to 7, more preferably 4 to 6. The sulfonic acid moieties of the polymerization product may be converted to H type moieties by ion exchange, and then may be neutralized by the alkali such as sodium hydroxide and ammonium hydroxide. Also in the neutralization, the pH value adjusted is preferably 3 to 7, more preferably 4 to 6. The polymer for the anode buffer layer of the invention can be obtained by evaporating water from the neutralized solution.

A second aspect of the invention pertains to an anode buffer layer coating solution containing the polymer for the anode buffer layer according to the first aspect.

The polymer for the anode buffer layer is water-soluble, and the solvent for the anode buffer layer coating solution is preferably water. In the anode buffer layer coating solution, the content of the anode buffer polymer is preferably 0.1 to 10% by mass, more preferably 0.5 to 5% by mass.

The anode buffer layer coating solution may contain a surfactant to improve the wettability to the substrate. Examples of the surfactants usable in the invention include anionic surfactants such as carboxylate salts, α-olefin sulfonate salts, alkylbenzene sulfonate salts, alkyl sulfonate salts, alkyl ether sulfonate ester salts, and alkylsulfonate triethanolamines; cationic surfactants such as alkyltrimethylammonium salts, dialkyldimethylammonium chlorides, and alkylpyridinium chlorides; ampholytic surfactants such as alkylcarboxybetaines; nonionic surfactants such as carboxylic diethanolamides, polyoxyethylene alkyl ethers, and polyoxyethylene alkyl phenyl ethers; etc. The ratio of the surfactant to the polymer for the anode buffer layer of the invention is preferably 100% by mass or less, more preferably 30% by mass or less.

The anode buffer layer coating solution may contain also a high-polar alcohol such as methanol, ethanol, and 2-propanol, to improve the wettability to the substrate. The ratio of the alcohol to the entire anode buffer layer coating aqueous solution is preferably 60% by mass or less.

The anode buffer layer coating solution may further contain various additives needed in a film forming process such as a spin coating method, an ink-jet method, and a printing method, and examples of the additives include thickeners, dispersing agents, antifoaming agents, antioxidants, light stabilizers, and lubricants.

According to an embodiment of the invention, there is provided an organic light emitting device having the anode buffer layer containing the polymer for the anode buffer layer according to the first aspect.

The anode buffer layer of the organic light emitting device of the invention may be formed by applying the anode buffer layer coating solution according to the second aspect onto the substrate provided with the anode, and by drying the solution to remove the solvent. The coating solution may be applied by a spin coating method, an ink-jet method, a printing method, a spray method, a dispenser method, etc. The thickness of the anode buffer layer is preferably 10 to 200 nm, more preferably 20 to 100 nm.

In the organic light emitting device of the invention, each compound used in the light emitting layer, the hole transporting layer, and the electron transporting layer may be a low or high molecular weight compound. High molecular weight compounds are preferably used to simplify the processes for producing the device because the anode buffer layer comprises the polymer compound.

Examples of the light emitting materials for forming the light emitting layer of the organic light emitting device of the invention include low molecular weight light emitting materials and high molecular weight light emitting materials described in Yutaka Ohmori, Oyo Buturi, Vol. 70, No. 12, Page 1419-1425 (2001), etc. Among the light emitting materials, particularly phosphorescent materials are preferred from the viewpoint of high light emitting efficiency. Further, light emitting polymer materials are preferred from the viewpoint of simplifying the processes for producing the device. Thus, phosphorescent polymer compounds are more preferred.

The structure of the phosphorescent polymer compound used for the light emitting layer in the organic light emitting device is not particularly restricted as long as the compound can emit phosphorescence at room temperature. A first example of the polymer structure of the phosphorescent polymer compound is such that a skeleton of a conjugated polymer such as a poly(p-phenylene), a poly(p-phenylenevinylene), a polyfluorene, a polythiophene, a polyaniline, a polypyrrole, and a polypyridine is bonded with a phosphorescent moiety. (The phosphorescent moiety may be typically a mono- or di-valent group of a complex of transition metal or rare earth metal to be hereinafter described.) In the polymer structure, the phosphorescent moiety may be contained in the main chain or the side chain.

Another example of the polymer structure of the phosphorescent polymer compound is such that a skeleton of a non-conjugated polymer such as a polyvinylcarbazole and a polysilane is bonded with the phosphorescent moiety. In the polymer structure, the phosphorescent moiety may be contained in the main chain or the side chain.

Further example of the structure of the phosphorescent polymer compound is a dendrimer having the phosphorescent moiety. In the structure, the phosphorescent moiety may be contained in the core, branched part, or end of the dendrimer.

In above structures of the polymer compound, phosphorescence is emitted from the phosphorescent moiety connected to the conjugated or non-conjugated skeleton. The polymer compound may be such that phosphorescence is emitted from the conjugated or non-conjugated skeleton. It is preferred that the phosphorescent polymer compound for the organic light emitting device of the invention is a polymer comprising the non-conj ugated skeleton with the phosphorescent moiety (hereinafter referred to as a non-conjugated phosphorescent polymer), because such a polymer is flexible in material design, phosphorescence can be relatively easily obtained from the polymer, the polymer can be easily synthesized, the polymer has a high solubility in solvents, and thereby the coating solution can be easily prepared.

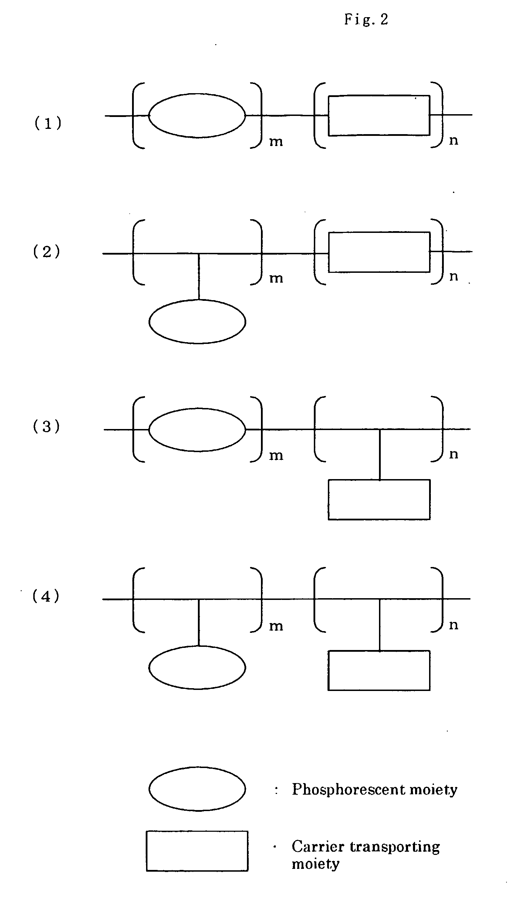

The non-conjugated phosphorescent polymer described above comprises the phosphorescent moiety and a carrier transporting moiety. As shown in Fig. 2, typical examples of the polymer structure containing connection between phosphorescent moiety and a carrier transporting moiety include (1) a structure where both of the phosphorescent moiety and the carrier transporting moiety are contained in the polymer main chain, (2) a structure where the phosphorescent moiety is contained in the polymer side chain and the carrier transporting moiety is contained in the polymer main chain, (3) a structure where the phosphorescent moiety is contained in the polymer main chain and the carrier transporting moiety is contained in the polymer side chain, and (4) a structure where both of the phosphorescent moiety and the carrier transporting moiety are contained in the polymer side chain. Further, the polymer may have a cross-linked structure.

The non-conjugated phosphorescent polymer may have two or more types of the phosphorescent moieties, which may be contained in the main chain or the side chain respectively. Further, the polymer may have two or more types of the carrier transporting moieties, which may be contained in the main chain or the side chain respectively.

The weight average molecular weight of the non-conjugated phosphorescent polymer is preferably 1,000 to 100,000, more preferably 5,000 to 50,000.

A mono-, di-, or poly-valent group of a compound capable of emitting phosphorescence at room temperature can be used as the phosphorescent moiety. The phosphorescent moiety is preferably a mono- or di-valent group of a transitionmetal complex or a rare earth metal complex. The transition metal in the transition metal complex may be a metal of the first transition element series of Sc with the atomic number 21 to Zn with the atomic number 30, the second transition element series of Y with the atomic number 39 to Cd with the atomic number 48, or the third transition element series of Hf with the atomic number 72 to Hg with the atomic number 80, of the Periodic Table of Elements. The rare earth metal in the rare earth metal complex may be a metal of the lanthanoid series of La with the atomic number 57 to Lu with the atomic number 71 of the Periodic Table of Elements.

The ligands of the transition metal complex and the rare earth metal complex include those described in G. Wilkinson (Ed.), Comprehensive Coordination Chemistry, Plenum Press, 1987, and Akio Yamamoto, Yuki Kinzoku Kagaku Kiso to Oyo, Shokabo Publishing Co., Ltd., 1982. Preferred examples of the ligands include halogen ligands; nitrogen-containing heterocyclic ligands (such as phenylpyridine ligands, benzoquinoline ligands, quinolinol ligands, bipyridyl ligands, terpyridine ligands, and phenanthroline ligands) ; diketone ligands (such as acetylacetone ligands and dipivaloylmethane ligands); carboxylic acid ligands (such as acetic acid ligands); phosphine ligands (such as triphenylphosphine ligands and phosphite ester ligands) ; carbon monoxide ligands; isonitrile ligands; and cyano ligands. A single metal complex may contain several types of the ligands. Further, each of the metal complexes may be a bi- or poly-nuclear complex.

The carrier transporting moiety may be a mono-, di-, or poly-valent group of a hole transporting compound, an electron transporting compound, or a bipolar compound capable of transporting holes and electrons. Examples of the hole transporting type carrier transporting moieties include mono- or di-valent groups of carbazole, triphenylamine and N,N'-diphenyl-N,N'-(3-methylphenyl)-1,1'-biphenyl-4,4'-diami ne (TPD). Examples of the electron transporting type carrier transporting moieties include mono- or di-valent groups of quinolinol derivative metal complexes such as tris(quinolinol) aluminum (Alq₃), oxadiazole derivatives, triazole derivatives, imidazole derivatives and triazine derivatives. Further, examples of the bipolar carrier transporting moieties include mono- or di-valent groups of 4,4'-N,N'-dicarbazole-biphenyl (CBP).

In the organic light emitting device of the invention, the light emitting layer may comprise only the above-described phosphorescent polymer compound. Further, the light emitting layer may comprise a composition prepared by mixing the phosphorescent polymer compound with another carrier transporting compound to complement the carrier transporting properties of the phosphorescent polymer compound. Thus, the hole transporting type phosphorescent polymer compound may be combined with an electron transporting compound, and the electron transporting type phosphorescent polymer compound may be combined with the hole transporting compound. The carrier transporting compound used in combination with the phosphorescent polymer compound may be a low or high molecular weight compound.

Examples of the low molecular weight hole transporting compounds used in combination with the phosphorescent polymer compound include conventionally known hole transporting compounds such as triphenylamine derivatives such as N,N'-diphenyl-N,N'-(3-methylphenyl)-1,1'-biphenyl-4,4'-diami ne (TPD), 4,4'-bis[N-(1-naphthyl)-N-phenylamino]biphenyl (α-NPD), and 4,4',4''-tris(3-methylphenylphenylamino)triphenylamine (m-MTDATA). Examples of the high molecular weight hole transporting compounds used in combination with the phosphorescent polymer compound include polyvinylcarbazoles, polymers produced by introducing a polymerizable functional group into a triphenylamine-based low molecular weight compound such as polymer compounds with triphenylamine structures disclosed in JP-A-8-157575.

Examples of the low molecular weight electron transporting compounds used in combination with the phosphorescent polymer compound include quinolinol derivative metal complexes such as tris(quinolinol) aluminum (Alq₃), oxadiazole derivatives, triazole derivatives, imidazole derivatives and triazine derivatives. Examples of the high molecular weight electron transporting compounds used in combination with the phosphorescent polymer compound include polymers produced by introducing a polymerizable functional group into the above low molecular weight electron transporting compound such as polyphenylbiphenyloxadiazole(polyPBD) (polyPBD) disclosed in JP-A-10-1665.

Further, to improve the physical properties, etc. of the film of the phosphorescent polymer compound, a polymer compound having no direct effect on the light emitting properties of the phosphorescent polymer compound may be added and thus-obtained composition may be used as the light emitting material. For example, a PMMA (polymethyl methacrylate) or a polycarbonate may be added to make the resultant film flexible.

The thickness of the light emitting layer is preferably 1 nm to 1 µm, more preferably 5 nm to 300 nm, further preferably 10 nm to 100 nm.

In the organic light emitting device of the invention, the hole transportingmaterial for forming the hole transporting layer may be a known low molecular weight hole transporting material, and examples thereof include triphenylamine derivatives such as N,N'-dimethyl-N,N'-(3-methylphenyl)-1,1'-biphenyl-4,4'-diami ne (TPD), 4,9'-bis[N-(1-naphthyl)-N-phenylamino]biphenyl(α-NPD), and 4,4',4''-tris(3-methylphenylphenylamino)triphenylamine (m-MTDATA), and polyvinylcarbazoles. The hole transporting material may be a high molecular weight hole transporting materials, and examples thereof include polymers produced by introducing a polymerizable functional group into a triphenylamine-based low molecular weight compound such as polymer compounds with a triphenylamine skeleton disclosed in JP-A-8-157575, and polymer materials such as poly(para-phenylenevinylene)s and polydialkylfluorene. These hole transporting materials may be used singly, or mixed or layered with a different hole transporting material. The thickness of the hole transporting layer is preferably 1 nm to 5 µm, more preferably 5 nm to 1 µm, further preferably 10 nm to 500 nm.

In the organic light emitting device of the invention, the electron transporting material for the electron transporting layer may be a known low molecular weight electron transporting material, and examples thereof include quinolinol derivative metal complexes such as tris(quinolinol) aluminum (Alq₃), oxadiazole derivatives, triazole derivatives, imidazole derivatives and triazine derivatives. Further, the electron transporting material may be a high molecular weight electron transporting material, and examples thereof include polymers produced by introducing a polymerizable functional group into the above-mentioned low molecular weight electron transporting compound, such as polyphenylbiphenyloxadiazole(polyPBD) disclosed in JP-A-10-1665. These electron transporting materials may be used singly, or mixed or layered with a different electron transporting material. The thickness of the electron transporting layer is preferably 1 nm to 5 µm, more preferably 5 nm to 1 µm, further preferably 10 nm to 500 nm.

Each of the phosphorescent polymer compound for the light emitting layer described above, the hole transporting material for the hole transporting layer, and the electron transporting material for the electron transporting layer may be used alone or in combination with a binder of a polymer material to form each layer. Examples of the polymer materials for the binder include polymethyl methacrylates, polycarbonates, polyesters, polysulfones and polyphenylene oxides.

The light emitting layer, the hole transporting layer, and the electron transporting layer can be formed by a resistance heating deposition method, an electron beam deposition method, a sputtering method, an ink-jet method, a spin coating method, a dip coating method, a printing method, a spray method, a dispenser method, etc. The low molecular weight compounds are formed into a layer generally by a resistance heating deposition method or an electron beam deposition method, and the high molecular weight compounds are formed into a layer generally by an ink-jet method or a spin coating method.

A hole blocking layer may be formed on the cathode side of the light emitting layer in order that holes can be prevented from passing through the light emitting layer to be efficiently recombined with electrons in the light emitting layer. The hole blocking layer may comprise a compound having a deeper energy level of highest occupied molecular orbital (HOMO) than that of the light emitting material, and examples there of include triazole derivatives, oxadiazole derivatives, phenanthroline derivatives and aluminum complexes.

An exciton blocking layer may be formed on the cathode side of the light emitting layer to prevent deactivation of excitons due to the cathode metal. The exciton blocking layer may comprise a compound having an excited triplet energy larger than that of the light emitting material, and examples there of include triazole derivatives, phenanthroline derivatives and aluminum complexes.

The anode of the organic light emitting device of the invention may comprise a known transparent conductive material, and examples of the materials include indium tin oxide (ITO), tin oxide, zinc oxide, and conductive polymers such as polythiophenes, polypyrroles and polyanilines. The electrode comprising the transparent conductive material preferably has a surface resistance of 1 to 50 Ω/square (ohm/square). The materials may be formed into a film by an electron beam deposition method, a sputtering method, a chemical reaction method, a coating method, etc. The anode preferably has a thickness of 50 to 300 nm.

In the organic light emitting device of the invention, the cathode may comprise a known material having a small work function and chemical stability, and examples of the materials include Al, Mg-Ag alloys and alloys of Al and alkali metals such as Al-Li alloys and Al-Ca alloys. It is preferred that the work function of the material is 2.9 eV or more from the viewpoint of the chemical stability. The cathode can be formed from the material by a resistance heating deposition method, an electron beam deposition method, a sputtering method, an ion plating method, etc. The thickness of the cathode is preferably 10 nmto 1 µm, more preferably 50 to 500 nm.

A metal layer lower in work function than the cathode may be disposed as a cathode buffer layer between the cathode and the adjacent organic layer, to buffer the injection barrier for the electron injection from the cathode to the organic layer, thereby increasing the electron injection efficiency. Examples of the metals with a lower work function, which can be used in the cathode buffer layer, include alkali metals such as Na, K, Rb, and Cs and alkaline earth metals such as Sr and Ba, rare earth metals such as Pr, Sm, Eu, and Yb. An alloy or a metal compound may be used for the cathode buffer layer as long as it is lower in work function than the cathode. The cathode buffer layer may be formed by a vapor deposition method, a sputtering method, etc. The thickness of the cathode buffer layer is preferably 0.05 to 50 nm, more preferably 0.1 to 20 nm, further preferably 0.5 to 10 nm.

The cathode buffer layer may comprise a mixture of the above material having a small work function and an electron transporting material. The electron transporting material used in the cathode buffer layer may be the above-described organic compound for the electron transporting layer. In this case, the cathode buffer layermaybe formed by a codepositionmethod. Further, the cathode buffer layer may be formed from a solution by a spin coating method, a dip coating method, an ink-jet method, a printing method, a spray method, a dispenser method, etc. In this case the thickness of the cathode buffer layer is preferably 0.1 to 100 nm, more preferably 0.5 to 50 nm, further preferably 1 to 20 nm.

In the organic light emitting device of the invention, the substrate may be an insulating substrate transparent against the emission wavelength of the light emitting material. The substrate may comprise a known material of a glass or a transparent plastic such as PET (polyethylene terephthalate) and polycarbonate.

### BEST MODE FOR CARRYING OUT THE INVENTION

The present invention will be explained in more detail below referring to representative Synthesis Examples and Examples. The Examples are considered in all respects to be illustrative, and the invention as defined by the claims is not restricted thereto.

Measuring apparatuses used in Examples are as follows. Unless otherwise noted, reagents used in Examples are commercial products (special grade) without purifying them .
1) ¹H-NMR
   JNM EX270 manufactured by JEOL Ltd., 270 MHz
   Solvent: Chloroform-d
2) Elemental analysis apparatus
   CHNS-932 manufactured by LECO Corporation
3) GPC measurement (molecular weight measurement)
   Column: Shodex KF-G + KF804L + KF802 + KF801
   Eluent: Tetrahydrofuran (THF)
   Temperature: 40°C
   Detector: RI (Shodex RI-71)
4) ICP elemental analysis
   ICPS 8000 manufactured by Shimadzu Corporation

### Synthesis Example 1: Synthesis of polymer for the anode buffer layer, poly(5-sulfoisothianaphthene-1,3-yl) (hereinafter referred to as polySITN)

A polymer with H-type sulfonic acid groups was obtained according to a method disclosed in JP-A-6-49183, Example 3. 3.5 g of 1 N ammonium hydroxide was added to 100 ml of a 1% by mass aqueous solution of the obtained polymer, to adjust the pH value to 4.4. Water was evaporated from the aqueous polymer solution to obtain 0.99 g of a navy blue polymer. The mole fraction of the self-dopingmonomer corresponding to the formula (2) was 0.21, which was calculated from the amount of the alkali required for the neutralization. The polymer had a weight average molecular weight of 17,200, obtained by a GPC measurement with polystyrene standard.

### Synthesis Example 2: Synthesis of phosphorescent monomer, [6-(4-vinylphenyl)-2,4-hexanedionato]-bis(2-phenylpyridine) iridium (III) (hereinafter referred to as IrPA)

IrPA was synthesized according to a method disclosed in JP-A-2003-113246.

### Synthesis Example 3: Synthesis of phosphorescent copolymer, poly(N-vinylcarbazole-co-[6-(4-vinylphenyl)-2,4-hexanedionat o]-bis(2-phenylpyridine) iridium (III)) (hereinafter referred to as poly(VCz-co-IrPA))

The above copolymer was synthesized as a light emitting material containing a light emitting moiety of IrPA and a hole transporting moiety of N-vinylcarbazole.

1.55 g (8.0 mmol) of N-vinylcarbazole, 29 mg (0.04 mmol) of [6-(4-vinylphenyl)-2,4-hexanedionato]bis (2-phenylpyridine)iridium (III) (Ir(ppy)₂[1-(StMe)-acac]), and 13 mg (0.08 mmol) of AIBN were dissolved in 40 ml of dry toluene, and argon was passed therethrough for 1 hour. The resultant solution was heated to 80°C to initiate the polymerization reaction, and then stirred for 8 hours. The reaction liquid was cooled and added dropwise to 250 ml of methanol, whereby a polymer was precipitated and isolated by filtration. The isolated polymer was dissolved in 25 ml of chloroform, the resultant solution was added dropwise to 250 ml of methanol, whereby the polymer was purified by reprecipitation. The polymer was vacuum-dried at 60°C for 12 hours to obtain 1.14 g of the subject substance poly(VCz-co-IrPA) with a recovery rate of 72%. The polymer had a number average molecular weight of 4,800 and a weight average molecular weight of 11,900, obtained by a GPC measurement with polystyrene standard. Further, the polymer had a phosphorescent Ir complex moiety content of 0. 62 mol% obtained by an ICP elemental analysis.

### Synthesis Example 4: Synthesis of electron transporting polymer compound, polyphenylbiphenyloxadiazole (polyPBD) of formula (5)

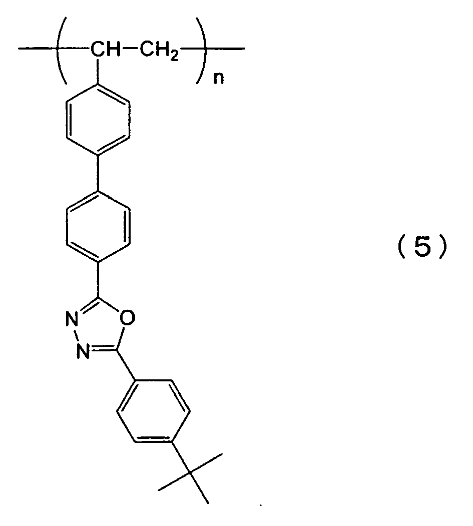

A polyPBD was synthesized according to a method disclosed in JP-A-10-1665. The polyTPD had a number average molecular weight of 32, 400 and a weight average molecular weight of 139, 100, obtained by a GPC measurement with polystyrene standard.

### Example 1: Surface resistance and conductivity of self-doping polyisothianaphthene film

A 1% by mass aqueous solution of the polySITN synthesized in Synthesis Example 1 was prepared, applied onto a glass substrate by a spin coater at 3,000 rpm for 60 seconds, and dried at 140°C for 30 minutes. As a result, a film with 30 nm thickness was obtained. The surface resistance of the film, measured by Megaresta Model HT-301 manufactured by Shishido Electrostatic, Ltd., was 6×10⁵ Ω/square. The film had a conductivity of 1.8 S/cm calculated from the surface resistance value.

### Example 2: Production and light emitting properties of organic light emitting device (fluorescent device) having anode buffer layer of self-doping polyisothianaphthene

An organic light emitting device was produced using an indium tin oxide(ITO)-having substrate available from Nippo Electric Co., Ltd. The ITO-having substrate comprised a 25-mm-square glass substrate and two 4-mm-width ITO electrodes, which were formed in stripe as an anode on one surface of the glass substrate. Prepared first was a coating solution for forming an anode buffer layer, which was a 1% by mass aqueous solution of the polySITN synthesized in Synthesis Example 1. The coating solution had a pH value of 4.4. The coating solution was applied onto the ITO-having substrate by a spin coater at 3, 000 rpm for 30 seconds, and dried at 140°C for 30 minutes to form an anode buffer layer. The obtained anode buffer layer had a thickness of approximately 30 nm. Then, a coating solution for forming a light emitting layer was prepared. That is, 45 mg of poly(2-methoxy-5-(2'-ethylhexyloxy)-1,4-phenylenevinylene) ADS100RE available from American Dye Source Inc. (hereinafter referred to as MEH-PPV) was dissolved in 2,955 mg of tetrahydrofuran (special grade, available from Wako Pure Chemical Industries, Ltd.), and the resulting solution was passed through a filter with a pore size of 0.2 µm to obtain the coating solution. The obtained coating solution was applied onto the anode buffer layer by a spin coating method at a rotation rate of 3,000 rpm for an application time of 30 seconds, and dried at 140°C for 30 minutes to form the light emitting layer. The light emitting layer had a thickness of approximately 100 nm. Then, the substrate coated with the light emitting layer was placed in a deposition apparatus, calcium was deposited thereon into a thickness of 25 nm at a deposition rate of 0.1 nm/s, and aluminum was deposited as a cathode to a thickness of 250 nm at a deposition rate of 1 nm/s. The calcium layer and the aluminum layer were each formed into two 3-mm-width stripes perpendicular to the longitudinal direction of the anode. Lead wires were connected to the anode and the cathode under an argon atmosphere lastly, so that four 4-mm-long, 3-mm-wide, organic light emitting devices were produced per one substrate. Each of the organic EL devices was driven by applying voltage using a programmable direct voltage/current source (TR6143) manufactured by Advantest Corporation, whereby the luminance was measured by a luminance meter BM-8 manufactured by Topcon Corporation. As a result, the organic light emitting devices had the maximum luminance, the maximum external quantum efficiency, and the luminance half-life at an initial luminance of 100 cd/m² shown in Table 1 (as average values of the four devices formed on one substrate).

### Example 3: Production and light emitting properties of organic light emitting device (phosphorescent device) having anode buffer layer of self-doping polyisothianaphthene

Organic light emitting devices were produced and evaluated on light emitting properties in the same manner as Example 2 except that a light emitting layer was formed as follows. 63.0 mg of poly(VCz-co-IrPA) synthesized in Synthesis Example 3 and 27.0 mg of polyPBD synthesized in Synthesis Example 4 were dissolved in 2, 910 mg of toluene (special grade, available from Wako Pure Chemical Industries, Ltd.), and the resulting solution was passed through a filter with a pore size of 0.2 µm to obtain a coating solution. The obtained coating solution was applied onto the anode buffer layer by a spin coater at 3, 000 rpm for 30 seconds, and dried at 140°C for 30 minutes to form the light emitting layer. The light emitting layer had a thickness of approximately 80 nm. As a result, the organic light emitting devices had the maximum luminance, the maximum external quantum efficiency, and the luminance half-life at an initial luminance of 100 cd/m² shown in Table 1 (as average values of the four devices formed on one substrate).

### Comparative Example 1: Production and light emitting properties of organic light emitting device (fluorescent device) having anode buffer layer of mixture of poly(3,4-ethylenedioxythiophene) and polystyrene sulfonate

Organic light emitting devices were produced and evaluated on light emitting properties in the same manner as Example 2 except that an anode buffer layer was formed as follows. An aqueous solution of a mixture of poly(3,4-ethylenedioxythiophene) and polystyrene sulfonate, BAYTRON CH8000 (trade name, available from Bayer Co.), was used as a coating solution for forming the anode buffer layer. The coating solution had a solid content of 2.8% by mass, and after the coating solution was diluted with water until the solid content became 1% by mass, the pH value was 2.4. The coating solution was applied onto the ITO-having substrate by a spin coater at 3,500 rpm for 40 seconds, and dried at 140°C for 30 minutes to form the anode buffer layer. The anode buffer layer had a thickness of approximately 50 nm. As a result, the organic light emitting devices had the maximum luminance and the luminance half-life at an initial luminance of 100 cd/m² shown in Table 1 (as average values of the four devices formed on one substrate).

### Comparative Example 2: Production and light emitting properties of organic light emitting device (phosphorescent device) having anode buffer layer of mixture of poly(3,4-ethylenedioxythiophene) and polystyrene sulfonate

Organic light emitting devices were produced and evaluated on light emitting properties in the same manner as Comparative Example 1 except that a light emitting layer was formed as follows. 63.0 mg of poly(VCz-co-IrPA) synthesized in Synthesis Example 3 and 27.0 mg of polyPBD synthesized in Synthesis Example 4 were dissolved in 2,910 mg of toluene (special grade, available from Wako Pure Chemical Industries, Ltd.), and the resulting solution was passed through a filter with a pore size of 0.2 µm to obtain a coating solution. The obtained coating solution was applied onto the anode buffer layer by a spin coater at 3,000 rpm for 30 seconds, and dried at 140°C for 30 minutes to form the light emitting layer. The light emitting layer had a thickness of approximately 80 nm. As a result, the organic light emitting devices had the maximum luminance, the maximum external quantum efficiency, and the luminance half-life at an initial luminance of 100 cd/m² shown in Table 1 (as average values of the four devices formed on one substrate).

### Comparative Example 3: Production and light emitting properties of organic light emitting device (fluorescent device) having anode buffer layer of self-doping polyaniline

Organic light emitting devices were produced and evaluated on light emitting properties in the same manner as Example 2 except that an anode buffer layer was formed as follows. An aqueous solution of poly(aniline sulfonic acid) (hereinafter referred to as polySAN) available from Sigma-Aldrich Japan K. K. was used as a coating solution for forming the anode buffer layer. The coating solution had a solid content of 5% by mass, and after the coating solution was diluted with water until the solid content became 1% by mass, the pH value was 2.5. The coating solution was applied onto the ITO-having substrate by a spin coater at 5,000 rpm for 30 seconds, and dried at 140°C for 30 minutes to form the anode buffer layer. The anode buffer layer had a thickness of approximately 60 nm. As a result, the organic light emitting devices had the maximum luminance and the luminance half-life at an initial luminance of 100 cd/m² shown in Table 1 (as average values of the four devices formed on one substrate).

### Comparative Example 4: Production and light emitting properties of organic light emitting device (phosphorescent device) having anode buffer layer of self-doping polyaniline

Organic light emitting devices were produced and evaluated on light emitting properties in the same manner as Comparative Example 3 except that a light emitting layer was formed as follows. 63.0 mg of poly(VCz-co-IrPA) synthesized in Synthesis Example 3 and 27.0 mg of polyPBD synthesized in Synthesis Example 4 were dissolved in 2, 910 mg of toluene (special grade, available from Wako Pure Chemical Industries, Ltd.), and the resulting solution was passed through a filter with a pore size of 0.2 µm to obtain a coating solution. The obtained coating solution was applied onto the anode buffer layer by a spin coater at 3,000 rpm for 30 seconds, and dried at 140°C for 30 minutes to form the light emitting layer. The light emitting layer had a thickness of approximately 80 nm. As a result, the organic light emitting devices had the maximum luminance, the maximum external quantum efficiency, and the luminance half-life at an initial luminance of 100 cd/m² shown in Table 1 as average values of the four devices formed on one substrate.

**Table 1**

| Examples and Comparative Examples | Anode buffer layer | Light emitting layer | Maximum luminance (cd/m²) | Maximum external quantum efficiency (%) | Luminance half-life (hr at 100 cd/m²) |
|---|---|---|---|---|---|
| Example 2 | PolySITN | MEH-PPV | 7,200 | 2.1 | 3,900 |
| Example 3 | PolySITN | Poly(VCz-co-IrPA) + polyPBD | 14,700 | 5.2 | 48 |
| Comparative Example 1 | BAYTRON CH8000 | MEH-PPV | 4,100 | 1.4 | 1,900 |
| Comparative Example 2 | BAYTRON CH8000 | Poly(VCz-co-IrPA) + polyPBD | 8,300 | 3.7 | 22 |
| Comparative Example 3 | PolySAN | MEH-PPV | 3,800 | 1.2 | 1,800 |
| Comparative Example 4 | PolySAN | Poly(VCz-co-IrPA) + polyPBD | 6,500 | 3.1 | 17 |

### INDUSTRIAL APPLICABILITY

By using the polymer for the anode buffer layer in the organic light emitting device of the invention, the deterioration of the light emitting layer due to an extrinsic dopant can be prevented, and the organic light emitting device with high light emitting efficiency can be provided.

Further, the anode buffer layer coating solution in the organic light emitting device of the invention has a low acidity, whereby the organic light emitting device can be produced under reduced production load.

## Claims

1. An organic light emitting device comprising at least one light emitting layer between an anode and a cathode, wherein the light emitting layer adjacent to the anode is an anode buffer layer comprising a self-doped conductive polymer having a pH value of 3 to 7 in a 1% by mass aqueous solution, wherein the polymer comprises a monomer unit represented by the following formula (1): 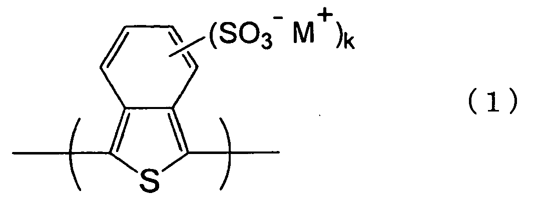 wherein M⁺ represents a hydrogen ion, an alkali metal ion, or a quaternary ammonium ion, k represents 1 or 2, and a hydrogen atom in the aromatic ring may be replaced by a substituent, and/or a monomer unit represented by the following formula (2): 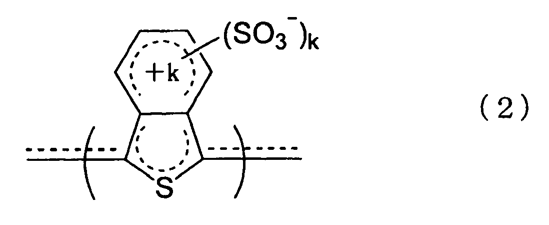 wherein k represents 1 or 2, +k represents a positive charge number, and a hydrogen atom in the aromatic ring may be replaced by a substituent.

2. The organic light emitting device according to claim 1, wherein the conductive polymer for an anode buffer layer has a weight average molecular weight of 1,000 to 200,000.

3. The organic light emitting device according to claim 1, wherein the polymer for an anode buffer layer is a polymer of 5-sulfoisothianaphthene-1,3-diyl, a random copolymer containing 5-sulfoisothianaphthene-1,3-diyl in an amount of 80 % by mass or more, poly(5-sulfoisothianaphthene-1,3-diyl-co-isothianaphthene-1,3-diyl) or a salt thereof.

4. The organic light emitting device according to any one of claims 1 to 3, wherein the light emitting layer comprises a fluorescent polymer material.

5. The organic light emitting device according to any one of claims 1 to 3, wherein the light emitting layer comprises a phosphorescent polymer material.

## Patentansprüche

1. Organisches Lichtemissionsbauelement, umfassend mindestens eine Lichtemissionsschicht zwischen einer Anode oder einer Kathode, wobei die an die Anode angrenzende Lichtemissionsschicht eine Anodenpufferschicht ist, welche ein selbstdotiertes leitfähiges Polymer mit einem pH-Wert von 3 bis 7 in einer 1 Massen-% wässrigen Lösung umfasst, wobei das Polymer eine Monomereinheit der folgenden Formel (1) aufweist: 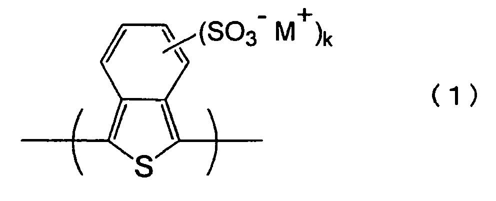 worin M⁺ ein Wasserstoffion, ein Alkalimetallion oder ein quaternäres Ammoniumion darstellt, k 1 oder 2 ist, und ein Wasserstoffatom in dem aromatischen Ring durch einen Substituenten ausgetauscht sein kann, und/oder eine Monomereinheit der folgenden Formel (2): 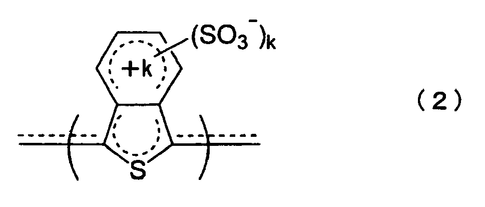 worin k 1 oder 2 ist, +k eine positive Ladungszahl darstellt, und ein Wasserstoffatom in dem aromatischen Ring durch einen Substituenten ausgetauscht sein kann.

2. Organisches Lichtemissionsbauelement nach Anspruch 1, wobei das leitfähige Polymer für eine Anodenpufferschicht ein Gewichtsmittel des Molekulargewichts von 1000 bis 2000 aufweist.

3. Organisches Lichtemissionsbauelement nach Anspruch 1, wobei das Polymer für eine Anodenpufferschicht ein Polymer von 5-Sulfoisothianaphthen-1,3-diyl, ein statistisches Copolymer, welches 5-Sulfoisothianaphthen-1,3-diyl in einer Menge von 80 Massen-% oder mehr enthält, Poly(5-sulfoisothianaphthen-1,3-diyl-co-isothianaphthen-1,3-diyl) oder ein Salz davon ist.

4. Organisches Lichtemissionsbauelement nach einem der Ansprüche 1 bis 3, worin die Lichtemissionsschicht ein fluoreszierendes Polymermaterial enthält.

5. Organisches Lichtemissionsbauelement nach einem der Ansprüche 1 bis 3, worin die Lichtemissionsschicht ein phosphoreszierendes Polymermaterial enthält.

## Revendications

1. Dispositif électroluminescent organique comprenant au moins une couche électroluminescente entre une anode et une cathode, où la couche électroluminescente adjacente à l'anode est une couche tampon d'anode comprenant un polymère conducteur auto-dopé ayant un pH de 3 à 7 dans une solution aqueuse à 1 % en masse, où le polymère comprend une unité monomère représentée par la formule (1) suivante : 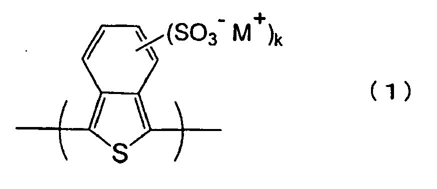 où M⁺ représente un ion hydrogène, un ion de métal alcalin ou un ion d'ammonium quaternaire, k représente 1 ou 2, et un atome d'hydrogène dans le cycle aromatique peut être remplacé par un substituant, et/ou une unité monomère représentée par la formule (2) suivante : 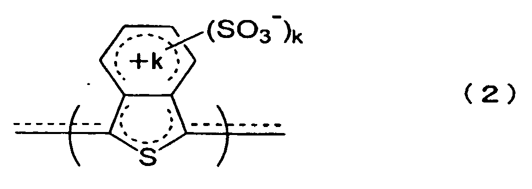 où k représente 1 ou 2, +k représente un nombre de charges positive, et un atome d'hydrogène dans le cycle aromatique peut être remplacé par un substituant.

2. Dispositif électroluminescente organique selon la revendication 1 où le polymère conducteur pour une couche tampon d'anode a une masse moléculaire moyenne en poids de 1 000 à 200 000.

3. Dispositif électroluminescente organique selon la revendication 1 où le polymère pour une couche tampon d'anode est un polymère de 5-sulfoisothianaphtène-1,3-diyle), un copolymère statistique contenant du 5-sulfoisothianaphtène-1,3-diyle) en une quantité de 80 % en masse ou plus, du poly(5-sulfoisothianaphtène-1,3-diyle-coisothanaphtène-1,3-diyle) ou un sel de celui-ci.

4. Dispositif électroluminescent organique selon l'une quelconque des revendications 1 à 3 où la couche électroluminescente comprend un matériau polymère fluorescent.

5. Dispositif électroluminescent organique selon l'une quelconque des revendications 1 à 3 où la couche électroluminescente comprend un matériau polymère phosphorescent.
